# EUROPEAN PATENT SPECIFICATION

(11) **EP 2 777 073 B1**
(45) Date of publication and mention of the grant of the patent: **27.09.2017**
(21) Application number: 12783497.6
(22) Date of filing: 23.10.2012
(51) Int. Cl.: H01L 23/373, H01L 23/473

(54) **POWER MODULE COOLING**
KÜHLUNG EINES STROMMODULS
REFROIDISSEMENT DE MODULE DE PUISSANCE

(30) Priority: 09.11.2011 DK 201100874
(43) Date of publication of application: 17.09.2014
(73) Proprietor: Danfoss A/S, 6430 Nordborg (DK)
(72) Inventor: OLESEN, Klaus, DK-6400 Sønderborg (DK); HOLST, Joergen, DK-6470 Sydals (DK); BREDTMANN, Rüdiger, 24857 Fahrdorf (DE)
(74) Representative: Knoblauch, Andreas
(86) International application number: PCT/DK2012/000115
(87) International publication number: WO 2013/068009

(56) References cited:
- WO-A1-2011/087028
- DE-A1-102010 001 565
- FR-A1- 2 786 658
- US-A1- 2012 048 515

## Description

### FIELD OF THE INVENTION

The present invention relates to cooling in power modules. In particular, the invention relates to cooling of power modules manufactured using direct copper bonding (DCB) or similar technologies.

### BACKGROUND OF THE INVENTION

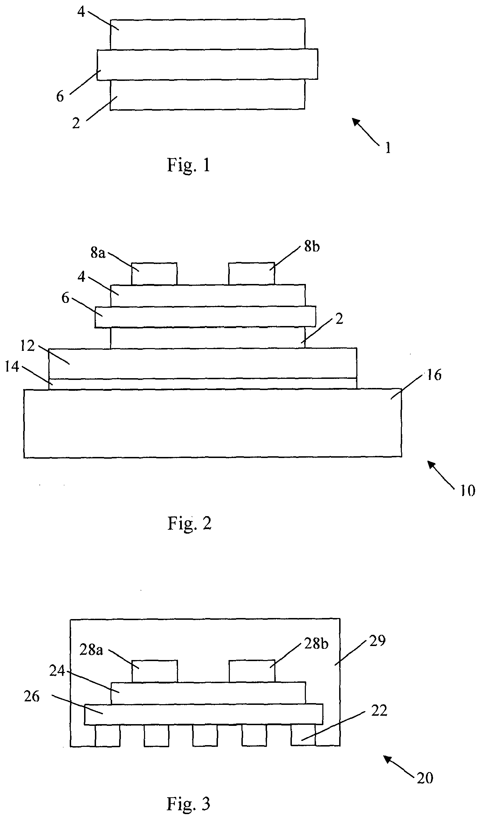

Figure 1 shows a known direct copper bonded (DCB) substrate, indicated generally by the reference numeral 1. Such substrates are sometimes called direct bonded copper (DBC) substrates in the art. The terms DCB substrate and DBC substrate are interchangeable. The term DCB substrate is used throughout this document for consistency.

The DCB substrate 1 comprises a lower conducting layer 2, an upper conducting layer 4 and an insulating layer 6. The insulating layer is provided in between the upper and lower conducting layers. The insulating layer 6 electrically isolates the upper and lower conducting layers. By way of example, the conducting layers 2 and 4 may be copper layers, although alternatives (such as aluminium) as possible. The insulating layer may be a ceramic layer. Possible materials for the insulating layer include alumina (Al₂O₃), aluminium nitride (AIN) and beryllium oxide (BeO). The skilled person will be aware of many alternative materials that could be used.

Power modules are often mounted on DCB substrates. Figure 2 shows a known power module, indicated generally by the reference numeral 10.

The power module 10 comprises the lower conducting layer 2, the upper conducting layer 4 and the insulating layer 6 described above. Circuit elements 8a and 8b of the power module (such as power transistors and diodes) are mounted on the second conducting layer 4, typically using surface mount technology. Of course, although two circuit elements are shown in the power module 10, many more circuit elements, and wiring connecting such circuit elements, may be provided.

The lower conducting layer is attached to a base plate 12, for example using a solder connection (not shown). The base plate 12 is in turn attached to a heat sink 16. As is well known in the art, a thermal interface material (TIM) 14 is provided between the base plate 12 and the heat sink 16. The TIM 14 is required since the base plate 12 and the heat sink 16 are not perfectly flat.

The heat sink 16 is used to dissipate heat generated by the circuit elements 8a and 8b. It is well known in the art that the thermal interface material 14 has a relatively high thermal resistance and therefore reduces the effectiveness of the cooling mechanism in the system 10. The interface between the heat sink 16 and air is also typically a source of significant thermal resistance.

Cooling of power modules is an important issue and is difficult due to the large amount of heat generated. In addition to the problems outlined above, cooling DCB substrates has two particular additional problems. First, the ceramic layer used in DCB substrates has low lateral thermal conductivity. Second, DCB substrates are typically fragile and cannot withstand the mechanical stresses applied by some cooling methodologies.

From DE 10 2010 001 565 A1 a power module is known, having a circuit assembly which comprises at least one power element arranged on a substrate, wherein the circuit assembly is housed at least in regions by a mold housing. A heatsink is housed in sections and made of a metal/ceramic composite material. The heatsink has an increasing ceramic content in the direction of the substrate and is allocated to the substrate.

In WO 2011 087 028 A1 a method of manufacturing substrates with integrated fins is disclosed. The bonding of metallic circuit boards with ceramic substrates is carried out by liquid metal bonding. The shaping of a plurality of radiator fins, which are to be cut out upon a portion of a metallic base plate, is caused by anchoring with a tool so as to apply stress tension upon the face whereupon the cut out portion radiator fins are formed, and carrying out a channel insertion process that forms a plurality of channels, by moving a multi-cutter, whereupon is layered a plurality of circular cutters, upon the face whereupon the stress tension has been applied, while rotating same.

The subsequently published US 2012 004 85 15 A1 shows a cooling apparatus including a direct-bonded copper ("DBC") substrate. The DBC substrate has a plurality of micro-structure tabs formed on a fluid impingement side of the DBC substrate, and a jet head in complementary opposition to the fluid impingement side. The jet head has a first plurality of micro-jets facing the fluid impingement side, each of the first plurality of micro-jets having a nozzle, and a second plurality of micro-jets facing the fluid impingement side so the jet head is configured to deliver a fluid to the plurality of micro-structure tabs through the first and second plurality of micro-jets.

FR 2 786 658 A1 shows a power electronic component with a composite structure for heat transfer. The composite structure comprises two plates, wherein adjacent grooves in the plates form channels for a cooling fluid. The grooves can be formed by etching.

### SUMMARY OF THE INVENTION

The present invention seeks to address at least some of the problems outlined above.

The present invention provides a power module comprising a first conducting layer (typically copper but alternatives exist, such as aluminium), a second conducting layer (typically copper but alternatives exist, such as aluminium), an insulating layer (typically a ceramic) between the first and second conducting layers, and a liquid cooling mechanism (or module), wherein: the first conducting layer is structured in order to increase surface area available for heat removal; circuit elements of the power module (e.g. diodes and power transistors) are provided on the second conducting layer (e.g. using surface mount technology); the first and second conducting layers, the insulating layer and the circuit elements are encapsulated leaving the first conducting layer (and possibly also some of the insulating layer) exposed to the liquid cooling mechanism; and the liquid cooling mechanism is configured to direct liquid into contact with the first conducting layer (and possibly also the insulating layer) in order to remove heat therefrom (thus, the liquid cooling mechanism is a direct liquid cooling mechanism), wherein the liquid cooling mechanism comprises a plurality of cells, wherein each cell is configured to direct liquid into contact with the first conducting layer in order to remove heat therefrom, wherein the first conducting layer is structured by removing material from the first conducting layer, wherein sufficient material is removed from the first conducting layer to expose the insulating layer.

The power module of the present invention brings cooling liquid into direct contact with the first conducting layer of the substrate. Thus, the thermal resistance between the source of heat (the circuit elements) and the cooling mechanism is low. The power module does not require a base plate, either for thermal control purposes or for mechanical stability. Omitting the base plate enables the cooling liquid to come into direct contact with the first conducting layer (and the insulating layer in some embodiments) and also provides a lightweight power module.

The liquid cooling mechanism ensures that the liquid coolant comes into contact with the power module. However, in addition, in many forms of the invention, directing liquid into contact with the first conducting layer (and possibly the insulating layer) comprises directing liquid towards the first conducting layer. The liquid power module may direct the incoming liquid towards the first conducting layer, for example by changing the direction of liquid flow so that the liquid is directed towards the power module (e.g. liquid may be directed substantially perpendicular to the surface of the first conducting layer). Directing cooling liquid towards the power module brings the liquid into contact with the power module as close as possible to the heat generating circuit elements.

The liquid cooling mechanism may comprise a liquid inlet and a liquid outlet. Thus, in some forms of the invention, the liquid cooling mechanism directs one or more (relatively cold) streams of liquid (received at the liquid inlet) towards the first conducting layer and removes one or more (relatively hot) streams of liquid (with those streams being directed out of the liquid cooling mechanism via the liquid outlet). In this way, heat can be transferred from the power module to the liquid, thereby cooling the power module.

The liquid cooling mechanism may comprise a plurality of cells, wherein each cell is configured to direct liquid into contact with the first conducting layer (e.g. by directing the liquid towards the first conducting layer) in order to remove heat therefrom. Each of the cells may include a liquid inlet and a liquid outlet. Liquid received at the liquid inlet of the liquid cooling mechanism may be distributed to the liquid inlets of the plurality of cells. Similarly, liquid returned to the liquid outlets of the cells may be directed to the liquid outlet of the liquid cooling mechanism.

Thus, each of the cells can be provided with liquid coolant having the same temperature. In this way, different parts of the power module are cooled in the same manner. Thus, inhomogeneous cooling (yielding large temperature gradients), which is a feature of many cooling modules having a single liquid inlet and a single liquid outlet, can be avoided. This is advantageous in arrangements where the power module includes power semiconductors operating in parallel, since the various power semiconductors receive similar cooling and therefore have similar operating conditions.

The liquid cooling mechanism may comprise a liquid inlet and a liquid outlet and a mechanism (the cells) for generating the plurality of liquid streams from liquid provided at the liquid inlet. In use, the liquid provided at the liquid inlet may be heated by the power module and the heated liquid streams returned to the liquid outlet.

In some forms of the invention, the first conducting layer is structured by removing material from the first conducting layer (e.g. by etching). Moreover, material may be removed from the first conducting layer such that some of the insulating layer is exposed (to the liquid cooling mechanism).

Alternatively, the first conducting layer may be structured by adding material to the first conducting layer (e.g. to create a pin-fin or similar structure).

One or more thermal buffers may be provided on the second conducting layer. The thermal buffer(s) may cover a portion (i.e. not all) of said second layer. Alternatively, or in addition, one or more thermal buffers may be provided over said circuit elements. The thermal buffer(s) may be provided at portions of the circuit with very high heat generation (e.g. where switching elements of a circuit are provided). This heat can be spread over the area of the thermal buffer before being removed. The thermal buffer also reduces lateral thermal resistance. A single thermal buffer may be provided for the power module. Alternatively, multiple thermal buffers may be provided. In one form of the invention, one thermal buffer per circuit element is provided. In another embodiments, some, but not all, of the circuit elements are provided with a thermal buffer.

The present invention also provides a method of removing heat from a power module, wherein the power module comprises a first conducting layer, a second conducting layer, an insulating layer between the first and second conducting layers, and a liquid cooling mechanism, wherein the first conducting layer is structured (e.g. by etching) in order to increase surface area available for heat removal, the method comprising using the liquid cooling mechanism to direct liquid into contact with the first conducting layer (and also the insulating layer in some embodiments) in order to remove heat therefrom. Directing liquid into contact with the first conducting layer may comprise directing liquid from the liquid cooling mechanism towards the first conducting layer.

Directing liquid into contact with the first conducting layer may comprise directing liquid from each of a plurality of cells into contact (e.g. towards) the first conducting layer. In some forms of the invention, each of the cells includes a liquid inlet and a liquid outlet. Liquid received at the liquid inlet of the liquid cooling mechanism may be distributed to the liquid inlets of the plurality of cells. Similarly, liquid returned to the liquid outlets of the cells may be directed to the liquid outlet of the power module. Thus, the liquid cooling mechanism may comprise a liquid inlet and a liquid outlet and a mechanism (the cells) for generating the plurality of liquid streams from liquid provided at the liquid inlet. In use, the liquid provided at the liquid inlet may be heated by the power module and the heated liquid streams are returned to the liquid outlet.

The method may include returning liquid that has been in contact with the first conducting layer to a liquid outlet of the liquid cooling mechanism.

### BRIEF DESCRIPTION OF THE DRAWINGS

The invention will now be described in further detail with reference to the following schematic drawings, in which:
Figure 1 shows a direct copper bonded substrate;
Figure 2 shows a known power module incorporating a direct copper bonded substrate;
Figure 3 shows a power module in accordance with an aspect of the present invention;
Figure 4 shows a view from below of the power module of Figure 3;
Figure 5 shows a power module in accordance with an aspect of the present invention incorporating a cooling module;
Figure 6 shows a portion of the direct liquid cooling mechanism used in an implementation of the power module of Figure 5; and
Figure 7 shows a power module in accordance with an aspect of the present invention incorporating a cooling module and a thermal mass.

### DETAILED DESCRIPTION OF THE INVENTION

Figure 3 shows a power module, indicated generally by the reference numeral 20. The power module 20 comprises a first conducting layer 22, a second conducting layer 24, an insulating layer 26, circuit elements 28a and 28b and an encapsulation material 29.

The second conducting layer 24 and the insulating layer 26 are similar to the upper conducting layer 4 and the insulating layer 6 described above. The circuit elements 28a and 28b are similar to the circuit elements 8a and 8b described above.

The power module 20 does not include a base plate. One impact of this is that the first conducting layer 22 is exposed on the lower side of the power module 20. This is made possible, in part, by the encapsulation of the power module in the encapsulation material 29, which provides mechanical stability. Not providing a base plate has the additional advantage that the power module 20 can be smaller and lighter than the power module 10 described above.

In addition to being exposed, the first conducting layer 22 is etched. Etching increases the surface area available to remove heat from the conducting layer 22, thereby making heat removal techniques more effective.

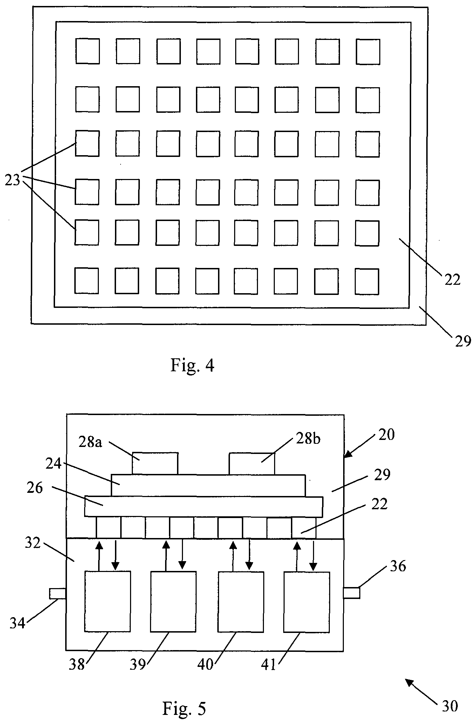

Figure 4 is a view of the power module 20 from below and shows the exposed first conducting layer 22 and the encapsulation material 29. As shown in Figure 4, the first conducting layer 22 includes a plurality of square holes etched into the conducting layer material. The square holes are etched in a square array. Of course, many other arrangements of etching the first conducting layer 22 will be readily apparent to those skilled in the art. For example, the array could be modified to provide more etching in areas in which more cooling is required (for example, at the location of circuit elements that produce large amounts of heat). Moreover, the array need not be a square array and the etched holes need not be square holes.

Figure 5 shows a power module and cooling system, indicated generally by the reference numeral 30, in accordance with an aspect of the present invention. The system 30 comprises the power module 20 described above and additionally includes a liquid cooling module 32. The liquid cooling module 32 has a liquid inlet 34 and a liquid outlet 36.

The liquid cooling module 32 includes a plurality of cells. A first cell 38, a second cell 39, a third cell 40 and a fourth cell 41 are shown in the exemplary system 30, although, of course, any number of cells could be provided.

Each cell directs relatively cool liquid received at the liquid inlet 34 towards the power module 20. The liquid is heated, thereby removing heat from the power module 20. Each cell subsequently directs the heated water to the liquid outlet 36 of the liquid cooling module 32.

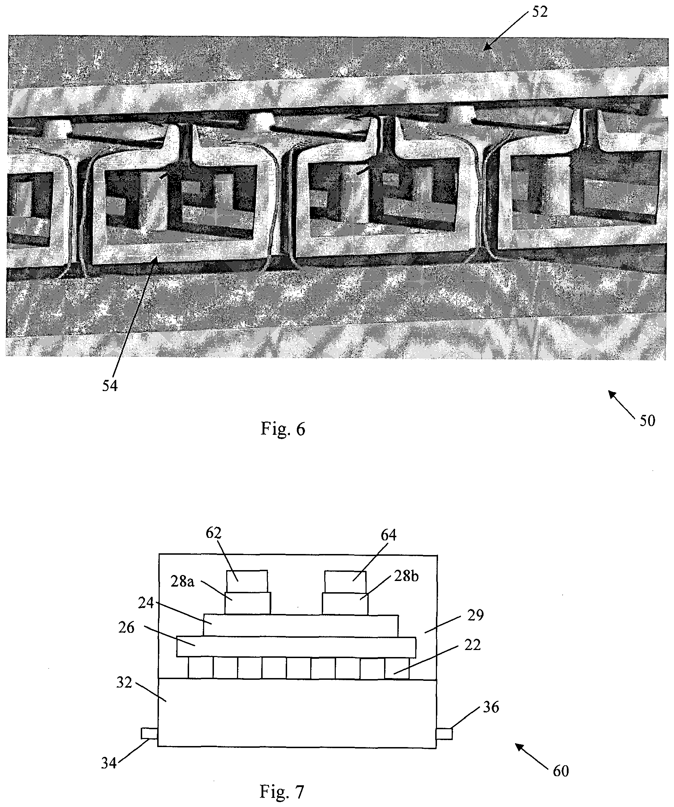

Figure 6 shows a portion, indicated generally by the reference numeral 50, of an exemplary implementation of the direct liquid cooling module 32.

The direct liquid cooling module implementation 50 comprises a surface 52 to be cooled and includes a plurality of cells, indicated generally by the reference numeral 54. As shown in Figure 6, cooling liquid is forced out of the top of the cells and into contact with the surface 52. The liquid then exits the module around the outside of the cells 54.

The exemplary implementation shown in Figure 6 is, of course, one of many possible implementations of the direct liquid cooling module 32. The skilled person will be aware of many alternatives that could be used in accordance with the principles of the present invention.

The power module 30 described above differs from the known power module 10 in at least the following ways:
1. The conducting layer 22 is etched.
2. The base plate 12, TIM 14 and heat sink 16 have been replaced with the liquid cooling system 32.
3. The power module is encapsulated.

Etching of the first conducting layer 22 has a number of advantages, including the increase in the surface area available for the liquid to remove heat from the conducting layer. Etching can also be used to guide liquid to hot spots in the first conducting layer 22 and/or the insulating layer 26.

As shown in Figure 3, the etching of the first conducting layer 22 may expose parts of the insulating layer 26. This is advantageous when used in combination is direct liquid cooling, since it enables cooling liquid to come in contact with the insulating layer 26, thereby removing heat very close to the heat sources (the circuit elements 28a and 28b in this example). Whilst the removal of material from the first conducting layer 22 through to the insulating layer 26 (whether by etching or otherwise) is advantageous in some embodiments of the invention, it is not essential to all embodiments of the invention.

Although etching of the first conducting layer is described in the exemplary embodiment above, this is not essential to all forms of the invention. For example, other processes such as machining, using different screen printing techniques, sputtering, and cold gas spraying can also provide the structure shown in Figures 3 and 4. Furthermore, an alternative to using etching or similar processes to remove material is to provide a pin fin structure, or some other form of projection from the first conducting layer. This could be thought of as the negative of the removal of material (e.g. by etching) as described above. The effect (increasing the surface area available for cooling) is, of course, the same.

Removing the need for a base plate, TIM and heat sink is advantageous since the liquid cooling arrangement can be applied very close to the source of the heat, rather than having a base plate between the source of the heat (the components of the power module) and the heat removal mechanism. Moreover, the use of a TIM is known to significantly increase thermal resistance in many prior art solutions. As noted above, removing the base plate and the heat sink reduces the size and weight of the power module. This is advantageous in many applications. For example, in the event that the power module is deployed in an electric vehicle, any reduction in weight will reduce the weight of the electric vehicle, and hence increase the efficiency of that vehicle.

Encapsulating the power module 20 in the encapsulation material 29 increases the mechanical stability of the power module. This makes it possible to dispense with the base plate and hence expose the first conducting layer 22 directly to the cooling mechanism (the liquid cooling module 32). Moreover, the additional mechanical stability ensures that the power module is able to withstand the mechanical stresses applied by the liquid cooling module 32.

Figure 7 shows a power module, indicated generally by the reference numeral 60, in accordance with an aspect of the present invention. The power module 60 includes the first conducting layer 22, second conducting layer 24, insulating layer 26, circuit elements 28a and 28b, encapsulation material 29 and liquid cooling module 32 described above. In addition, the power module 60 includes a first thermal buffer 62 and a second thermal buffer 64. The first thermal buffer 62 is provided above the first circuit element 28a: the second thermal buffer 64 is provided above the second circuit element 28b.

Each of the thermal buffers 62 and 64 are used to spread heat over the area of the thermal buffer. The thermal buffer can be used to reduce lateral thermal resistance, which can be a problem with power modules mounted on DCB substrates (due to the low lateral thermal conductivity of the ceramics typically used for the insulating layer 26).

As shown in Figure 7, some (or all) of the circuit elements mounted onto the second conducting layer 24 can be provided with a thermal buffer; however, there are many alternative arrangements. For example, a single thermal buffer may be provided for the power module. One or more thermal buffers may be provided on circuit elements (as shown in Figure 7) and/or or on top of the second conducting layer 24.

The use of thermal buffers is well known. The power module 30 described above has a very high cooling performance and so the need for heat spreading (e.g. using a thermal buffer) is reduced. The provision of a thermal buffer in the form of a heat spreader (such as the heat spreader 16 described above with reference to Figure 2) only adds to the overall thermal resistance of a power module without providing significant improvements in the transient behaviour (by reducing temperature swings). Providing a thermal buffer or some other heat spreader on the second conducting layer and/or on some or all of the circuit elements mounted on the second conducting layer can be used to reduce lateral thermal resistance and improve transient temperature behaviour, without increasing the thermal resistance between the power module and the liquid cooling module.

The embodiments of the invention described above make use of a direct liquid cooling module comprising a plurality of cells that each direct relatively cool liquid received at a liquid inlet towards the power module and return relatively hot liquid to a liquid outlet. This is not essential to all forms of the invention. The liquid cooling module ensures that the liquid coolant comes into contact with the power module, but not all forms of the invention require the incoming liquid to change the direction of liquid flow so that the liquid is directed towards the power module. The skilled person will be aware of many alternative direct liquid cooling systems that could be used in accordance with the principles of the present invention.

## Claims

1. A power module (20) comprising a first conducting layer (22), a second conducting layer (24), an insulating layer (26) between the first and second conducting layers (22, 24), and a liquid cooling mechanism (32), wherein:
the first conducting layer (22) is structured in order to increase surface area available for heat removal;
circuit elements (28a, 28b) of the power module (20) are provided on the second conducting layer (24);
the first and second conducting layers (22, 24), the insulating layer (26) and the circuit elements (28a, 28b) are encapsulated leaving the first conducting layer (22) exposed to the liquid cooling mechanism (32); and
the liquid cooling mechanism (32) is configured to direct liquid into contact with the first conducting layer (22) in order to remove heat therefrom,
**characterized in that** the liquid cooling mechanism (32) comprises a plurality of cells (38, 39, 40, 41, 54), wherein each cell (38, 39, 40, 41, 54) is configured to direct liquid into contact with the first conducting layer (22) in order to remove heat therefrom, and wherein the first conducting layer (22) is structured by removing material from the first conducting layer (22), wherein sufficient material is removed from the first conducting layer (22) to expose the insulating layer (26).

2. A power module as claimed in claim 1, **characterized in that** the liquid cooling mechanism (32) comprises a liquid inlet (34) and a liquid outlet (36).

3. A power module as claimed in claim 1 or 2, **characterized in that** each of the cells (38, 39, 40, 41, 54) includes a liquid inlet (34) and a liquid outlet (36).

4. A power module as claimed in any preceding claim, further **characterized by** one or more thermal buffers (62, 64) on the second conducting layer (24).

5. A power module as claimed in claim 4, **characterized in that** the or each thermal buffer (62, 64) covers a portion of said second layer (24).

6. A power module as claimed in any preceding claim, further **characterized by** one or more thermal buffers (62, 64) provided over at least some of said circuit elements (28a, 28b).

7. A method of removing heat from a power module (20), wherein the power module (20) comprises a first conducting layer (22), a second conducting layer (24), an insulating layer (26) between the first and second conducting layers (22, 24), wherein circuit elements (28a, 28b) of the power module (20) are provided on the second conducting layer (24), the first and second conducting layers (22, 24), the insulating layer (26) and the circuit elements (28a, 28b) are encapsulated leaving the first conducting layer (22) exposed to the liquid cooling mechanism (32); and a liquid cooling mechanism (32), wherein the first conducting layer (22) is structured in order to increase surface area available for heat removal, and wherein the first conducting layer (22) is structured by removing material from the first conducting layer (22), wherein sufficient material is removed from the first conducting layer (22) to expose the insulating layer (26), the method comprising using the liquid cooling mechanism (32) to direct liquid into contact with the first conducting layer (22) in order to remove heat therefrom, wherein directing liquid into contact with the first conducting layer (22) comprises directing liquid from each of a plurality of cells (38, 39, 40, 41, 54) towards the first conducting layer (22).

8. A method as claimed in claim 7, further **characterized by** returning liquid that has been in contact with the first conducting layer to a liquid outlet of the liquid cooling mechanism.

9. A method as claimed in any one of claims 7 or 8, **characterized in that** the first conducting layer (22) is structured by removing material from the first conducting layer (22) by etching.

## Patentansprüche

1. Leistungsmodul (20), aufweisend eine erste leitende Schicht (22), eine zweite leitende Schicht (24), eine isolierende Schicht (26) zwischen der ersten und der zweiten leitenden Schicht (22, 24), und einen Flüssigkeitskühlungsmechanismus (32), wobei:
die erste leitende Schicht (22) strukturiert ist, um die zur Wärmeabfuhr verfügbare Fläche zu vergrößern;
Schaltkreiselemente (28a, 28b) des Leistungsmoduls (20) auf der zweiten leitenden Schicht (24) vorgesehen sind;
die erste und die zweite leitende Schicht (22, 24), die isolierende Schicht (26), und die Schaltkreiselemente (28a, 28b) eingekapselt sind, wobei die erste leitende Schicht (22) dem Flüssigkeitskühlungsmechanismus (32) ausgesetzt verbleibt; und
der Flüssigkeitskühlungsmechanismus (32) konfiguriert ist, Flüssigkeit in einen Kontakt mit der ersten leitenden Schicht (22) zu führen, um Wärme daraus abzuführen,
**dadurch gekennzeichnet, dass** der Flüssigkeitskühlungsmechanismus (32) mehrere Zellen (38, 39, 40, 41, 54) aufweist, wobei jede Zelle (38, 39, 40, 41, 54) konfiguriert ist, Flüssigkeit in einen Kontakt mit der ersten leitenden Schicht (22) zu führen, um Wärme daraus abzuführen, und
wobei die erste leitende Schicht (22) durch Entfernen von Material aus der ersten leitenden Schicht (22) strukturiert ist, wobei aus der ersten leitenden Schicht (22) ausreichend Material entfernt ist, um die isolierende Schicht (26) freizulegen.

2. Leistungsmodul nach Anspruch 1, **dadurch gekennzeichnet, dass** der Flüssigkeitskühlungsmechanismus (32) einen Flüssigkeitseinlass (34) und einen Flüssigkeitsauslass (36) aufweist.

3. Leistungsmodul nach Anspruch 1 oder 2, **dadurch gekennzeichnet, dass** jede der Zellen (38, 39, 40, 41, 54) einen Flüssigkeitseinlass (34) und einen Flüssigkeitsauslass (36) aufweist.

4. Leistungsmodul nach einem der vorhergehenden Ansprüche, ferner **gekennzeichnet durch** einen oder mehrere thermische Puffer (62, 64) auf der zweiten leitenden Schicht (24).

5. Leistungsmodul nach Anspruch 4, **dadurch gekennzeichnet, dass** der oder jeder thermische Puffer (62, 64) einen Teil der zweiten Schicht (24) bedeckt.

6. Leistungsmodul nach einem der vorhergehenden Ansprüche, ferner **gekennzeichnet durch** einen oder mehrere thermische Puffer (62, 64), die über zumindest einigen der Schaltungselemente (28a, 28b) vorgesehen sind.

7. Verfahren zum Abführen von Wärme von einem Leistungsmodul (20), wobei das Leistungsmodul (20) aufweist: eine erste leitende Schicht (22), eine zweite leitende Schicht (24), eine isolierende Schicht (26) zwischen der ersten und der zweiten leitenden Schicht (22, 24), wobei Schaltkreiselemente (28a, 28b) des Leistungsmoduls (20) auf der zweiten leitenden Schicht (24) vorgesehen sind, wobei die erste und die zweite leitende Schicht (22, 24), die isolierende Schicht (26), und die Schaltkreiselemente (28a, 28b) eingekapselt sind, wobei die erste leitende Schicht (22) dem Flüssigkeitskühlungsmechanismus (32) ausgesetzt verbleibt; und einen Flüssigkeitskühlungsmechanismus (32), wobei die erste leitende Schicht (22) strukturiert ist, um die zur Wärmeabfuhr verfügbare Fläche zu vergrößern, und wobei die erste leitende Schicht (22) durch Entfernen von Material aus der ersten leitenden Schicht (22) strukturiert ist, wobei aus der ersten leitenden Schicht (22) ausreichend Material entfernt ist, um die isolierende Schicht (26) freizulegen, wobei das Verfahren aufweist: Verwenden des Flüssigkeitskühlungsmechanismus (32), um Flüssigkeit in einen Kontakt mit der ersten leitenden Schicht (22) zu führen, um Wärme daraus abzuführen, wobei das Führen von Flüssigkeit in einen Kontakt mit der ersten leitenden Schicht (22) ein Führen von Flüssigkeit von jeder von mehreren Zellen (38, 39, 40, 41, 54) zu der ersten leitenden Schicht (22) aufweist.

8. Verfahren nach Anspruch 7, ferner **gekennzeichnet durch** Zurückführen von Flüssigkeit, die mit der ersten leitenden Schicht in Kontakt war, zu einem Flüssigkeitsauslass des Flüssigkeitskühlungsmechanismus.

9. Verfahren nach einem der Ansprüche 7 oder 8, **dadurch gekennzeichnet, dass** die erste leitende Schicht (22) durch Entfernen von Material aus der ersten leitenden Schicht (22) durch Ätzen strukturiert ist.

## Revendications

1. Module de puissance (20) comprenant une première couche conductrice (22), une seconde couche conductrice (24), une couche isolante (26) entre les première et seconde couches conductrices (22, 24) et un mécanisme de refroidissement par liquide (32), dans lequel
la première couche conductrice (22) est structurée afin d'augmenter la surface disponible pour une évacuation de la chaleur ;
des éléments de circuit (28a, 28b) du module de puissance (20) sont disposés sur la seconde couche conductrice (24) ;
les première et seconde couches conductrices (22, 24), la couche isolante (26) et les éléments de circuit (28a, 28b) sont encapsulés en laissant la première couche conductrice (22) exposée au mécanisme de refroidissement par liquide (32) ; et
le mécanisme de refroidissement par liquide (32) est configuré pour diriger un liquide en contact avec la première couche conductrice (22) afin d'évacuer la chaleur de cette dernière,
**caractérisé en ce que** le mécanisme de refroidissement par liquide (32) comprend une pluralité de cellules (38, 39, 40, 41, 54), dans lequel chaque cellule (38, 39, 40, 41, 54) est configurée pour diriger un liquide en contact avec la première couche conductrice (22) afin d'évacuer la chaleur de cette dernière et dans lequel la première couche conductrice (22) est structurée en enlevant un matériau de la première couche conductrice (22), dans lequel une quantité suffisante de matériau est enlevée de la première couche conductrice (22) pour exposer la couche isolante (26) .

2. Module de puissance selon la revendication 1, **caractérisé en ce que** le mécanisme de refroidissement par liquide (32) comprend un orifice d'entrée de liquide (34) et un orifice de sortie de liquide (36).

3. Module de puissance selon la revendication 1 ou 2, **caractérisé en ce que** chaque cellule (38, 39, 40, 41, 54) comprend un orifice d'entrée de liquide (34) et un orifice de sortie de liquide (36).

4. Module de puissance selon l'une quelconque des revendications précédentes, **caractérisé en outre par** un ou plusieurs tampons thermiques (62, 64) sur la seconde couche conductrice (24).

5. Module de puissance selon la revendication 4, **caractérisé en ce que** le ou chaque tampon thermique (62, 64) recouvre une partie de ladite seconde couche (24) .

6. Module de puissance selon l'une quelconque des revendications précédentes, **caractérisé en outre par** un ou plusieurs tampons thermiques (62, 64) disposés sur au moins quelques-uns desdits éléments de circuit (28a, 28b) .

7. Procédé d'évacuation de la chaleur d'un module de puissance (20), dans lequel le module de puissance (20) comprend une première couche conductrice (22), une seconde couche conductrice (24), une couche isolante (26) entre les première et seconde couches conductrices (22, 24), dans lequel des éléments de circuit (28a, 28b) du module de puissance (20) sont disposés sur la seconde couche conductrice (24), les première et seconde couches conductrices (22, 24), la couche isolante (26) et les éléments de circuit (28a, 28b) sont encapsulés en laissant la première couche conductrice (22) exposée au mécanisme de refroidissement par liquide (32) ; et un mécanisme de refroidissement par liquide (32), dans lequel la première couche conductrice (22) est structurée afin d'augmenter la surface disponible pour une évacuation de la chaleur et dans lequel la première couche conductrice (22) est structurée en enlevant un matériau de la première couche conductrice (22), dans lequel une quantité suffisante de matériau est enlevée de la première couche conductrice (22) pour exposer la couche isolante (26), le procédé consistant à utiliser le mécanisme de refroidissement par liquide (32) pour diriger un liquide en contact avec la première couche conductrice (22) afin d'évacuer la chaleur de cette dernière, dans lequel le fait de diriger un liquide en contact avec la première couche conductrice (22) consiste à diriger un liquide provenant de chaque cellule d'une pluralité de cellules (38, 39, 40, 41, 54) vers la première couche conductrice (22).

8. Procédé selon la revendication 7, **caractérisé en outre par** le renvoi du liquide qui a été en contact avec la première couche conductrice, vers un orifice de sortie de liquide du mécanisme de refroidissement par liquide.

9. Procédé selon l'une quelconque des revendications 7 et 8, **caractérisé en ce que** la première couche conductrice (22) est structurée en enlevant un matériau de la première couche conductrice (22) par gravure.
